Europäisches Patentamt

European Patent Office

Office européen des brevets

(11) Veröffentlichungsnummer: **0 233 321**

**A2**

(12) **EUROPÄISCHE PATENTANMELDUNG**

(21) Anmeldenummer: 86114767.6

(22) Anmeldetag: 23.10.86

(51) Int. Cl.⁴: **H05K 3/30** , H05K 7/08 , H05K 3/34

(30) Priorität: 07.02.86 DE 3603819

(43) Veröffentlichungstag der Anmeldung:
26.08.87 Patentblatt 87/35

(84) Benannte Vertragsstaaten:
DE FR GB SE

(71) Anmelder: VDO Adolf Schindling AG
Gräfstrasse 103
D-6000 Frankfurt/Main(DE)

(72) Erfinder: Baeger, Holm, Dr.
Salzbornstrasse 1
D-6231 Schwalbach a.T.(DE)

(74) Vertreter: Klein, Thomas, Dipl.-Ing. (FH)
Sodener Strasse 9 Postfach 6140
D-6231 Schwalbach a. Ts.(DE)

(54) **Vorrichtung zur elektrisch leitenden Verbindung.**

(57) Bei einer Vorrichtung zur elektrisch leitenden Verbindung einer Flüssigkristallzelle mit einer Leiterplatte stehen die Flüssigkristallzelle und die Leiterplatte im wesentlichen aufeinander senkrecht und weisen zueinander passende Leiterbahnen auf, welche innerhalb eines von ihnen gebildeten Winkels durch Lot miteinander verbunden sind. In der Leiterplatte kann in einem Randbereich ein Schlitz zur Aufnahme eines Randbereichs der Flüssigkristallzelle angeordnet sein.

FIG. 1

## Vorrichtung zur elektrisch leitenden Verbindung

Die Erfindung betrifft eine Vorrichtung zur elektrisch leitenden Verbindung einer Flüssigkristallzelle mit einer Leiterplatte.

Zur Verbindung einer Flüssigkristallzelle mit einer, insbesondere eine Ansteuerschaltung tragenden Leiterplatte sind verschiedene Vorrrichtungen bekannt geworden. Eine häufig verwendete derartige Vorrichtung enthält ein Leitgummi -auch Zebrastreifen genannt. Dieses Leitgummi ist stabförmig mit rechteckigem Querschnitt und besteht aus einer Vielzahl von den Querschnitt ausfüllenden Scheiben, wobei jeweils eine isolierende und eine leitfähige einander abwechseln. Auf zwei gegenüberliegenden Seiten kann dann noch eine durchgehende Isolierschicht aufgebracht sein.

Diese Leitgummis haben an sich eine weite Verbreitung gefunden. Die Sicherheit und Dauerhaftigkeit derartiger Kontakte ist jedoch noch verbesserungsbedürftig. Außerdem sind Leitgummis lediglich zur Verbindung von Leiterbahnen, welche auf sich gegenüberstehenden parallelen Platten angeordnet sind, bekannt geworden.

Aus konstruktiven Gründen kann es jedoch vorteilhaft sein, die Leiterplatte senkrecht zu der Flüssigkristallzelle anzuordnen. Insbesondere bei Flüssigkristallzellen mit Negativdarstellung der Zeichen und Symbole ist eine Beleuchtung von der Rückseite her vorteilhaft und dazu eine Bauform mit senkrecht zueinander stehender Leiterplatte und Flüssigkristallzelle anzustreben.

Zur Verbindung senkrecht zueinander stehender Leiterplatten sind zwar verschiedene Vielfachsteckvorrichtungen bekannt geworden, welche jedoch wegen des mangelnden Schutzes der Kontakte im Vergleich zur Kontaktierung mittels Leitgummi korrosionsgefährdeter sind. Außerdem sind derartige Vielfachsteckverbindungen relativ aufwendig und sind nicht für einen derart geringen Kontaktabstand erhältlich, der für die Verbindung von Flüssigkristallzellen, insbesondere Punktmatrixanzeigen, mit der Ansteuerelektronik benötigt wird.

Aufgabe der vorliegenden Erfindung ist es, eine Vorrichtung anzugeben, mit welcher eine sichere und preiswerte Verbindung zwischen einer Flüssigkristallzelle und einer Leiterplatte ermöglicht wird.

Diese Aufgabe wird erfindungsgemäß dadurch gelöst, daß ein Leiterbahnen tragender Randbereich der Flüssigkristallzelle und die Leiterplatte im wesentlichen aufeinander senkrecht stehen und zueinander passende Leiterbahnen aufweisen, welche innerhalb des von ihnen gebildeten Winkels verlötet sind. Die erfindungsgemäße Vorrichtung hat den Vorteil, daß eine sichere Kontaktgabe auch über längere Zeit und in aggressiver Atmoshäre gewährleistet ist. Außerdem ist die Vorrichtung preiswert herzustellen.

Eine erste Weiterbildung der Erfindung ist dadurch gekennzeichnet, daß in der Leiterplatte in einem Randbereich ein Schlitz zur Aufnahme des Randbereichs der Flüssigkristallzelle angeordnet ist. Dadurch kann die Flüssigkristallzelle wie andere Bauelemente in die Leiterplatte eingesteckt und beispielsweise maschinell mit einem Schwallötbad oder auf herkömmliche Weise manuell eingelötet werden.

Eine andere Weiterbildung der Erfindung ist dadurch gegeben, daß mehrere Schlitze in der Leiterplatte in einer Reihe angeordnet sind und daß die Flüssigkristallzelle in ihrem Randbereich entsprechend den Zwischenräumen der Schlitze in der Leiterplatte Aussparungen aufweist. Durch diese Weiterbildung kann, insbesondere bei langen Flüssigkristallzellen, die Stabilität der Verbindung zwischen der Flüssigkristallzelle und der Leiterplatte erhöht werden. Ist dieses im Einzelfall nicht erforderlich, weil beispielsweise die Flüssigkristallzelle und die Leiterplatte auch anderweitig mechanisch miteinander verbunden sind, so kann auch gemäß einer anderen Weiterbildung der Schlitz zum Rand hin teilweise offen sein.

Gemäß einer anderen Weiterbildung sind die aus nicht lötbarem Material bestehenden Leiterbahnen im Randbereich der Flüssigkristallzelle mit einer lötbaren Schicht versehen, welche vorzugsweise aus Kupfer besteht.

Vorteilhafte Ausgestaltungen der Erfindung bestehen darin, daß auf der Leiterplatte elektrische Bauelemente, insbesondere eine Ansteuerschaltung für die Flüssigkristallzelle, eine oder mehrere Lampenfassungen für die Beleuchtung der Flüssigkristallzelle und/oder ein einen Reflektor bildenden Lichtkasten auf der Leiterplatte angeordnet sind und daß deren Anschlüsse mit den Leiterbahnen der Leiterplatten verlötet sind.

Schließlich besteht die Möglichkeit, zwei gegenüberliegende Randbereiche der Flüssigkristallzelle mit je einer Leiterplatte zu verbinden, was insbesondere bei vielen Anschlüssen der Flüssigkristallzelle vorteilhaft ist und zu einer besonders kompakten Baugruppe führt. Die Erfindung ist nicht auf eine feste Leiterplatte beschränkt, es kann auch eine biegsame Folie mit aufgebrachten Leiterbahnen verwendet werden.

Die Erfindung läßt zahlreiche Ausführungsformen zu. Einige davon sind - schematisch in der Zeichnung an Hand mehrerer Figuren dargestellt und nachfolgend beschrieben. Es zeigt:

Fig. 1 ein erstes Ausführungsbeispiel in perspektivischer Darstellung,

Fig. 2 die Leiterplatte und einen Teil der Flüssigkristallzelle des ersten Ausführungsbeispiels,

Fig. 3 eine Leiterplatte und einen Teil einer Flüssigkristallzelle eines zweiten Ausführungsbeispiels,

Fig. 4 eine Leiterplatte und einen Teil einer Flüssigkristallzelle eines dritten Ausführungsbeispiels,

Fig. 5 ein viertes Ausführungsbeispiel und

Fig. 6 die vergrößerte Darstellung einer Verbindung zwischen einer Flüssigkristallzelle und einer Leiterplatte.

Gleiche Teile sind in den Figuren mit gleichen Bezugszeichen versehen.

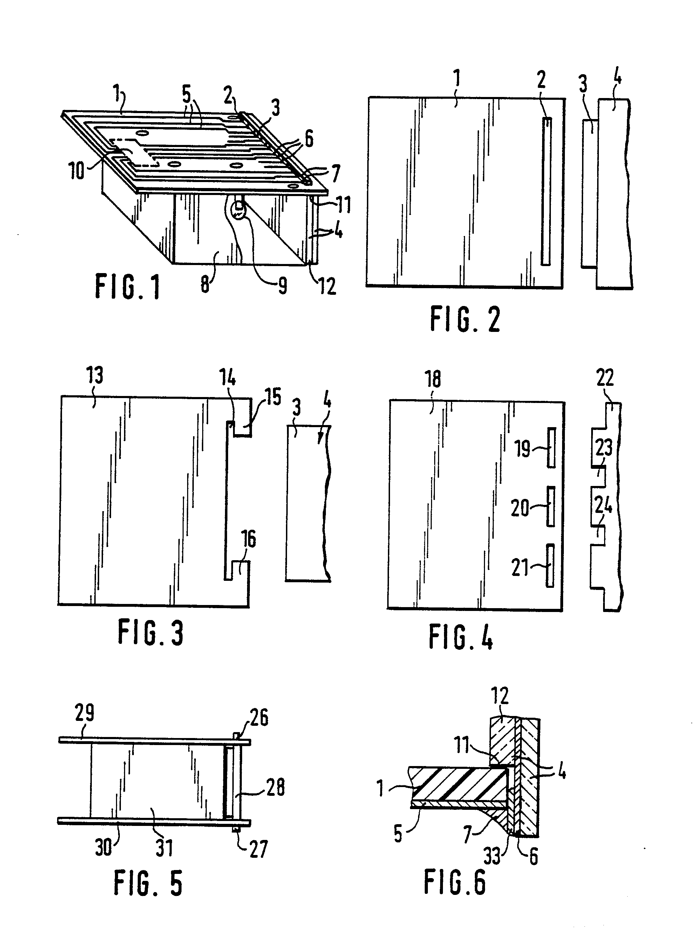

Bei der Anordnung nach Fig. 1 ist eine Leiterplatte 1 mit einem Schlitz 2 versehen, in welchen ein Randbereich 3 einer Flüssigkristallzelle 4 eingesteckt ist. Die zu verbindenden Leiterbahnen 5, 6 der Leiterplatte 1 und der Flüssigkristallzelle 4 bilden jeweils einen Winkel, der beim Überfahren eines Schwallötbades mit Lot 7 gefüllt wird. Dadurch ist eine elektrisch leitende und ebenfalls mechanisch feste Verbindung zwischen der Flüssigkristallzelle 4 und der Leiterplatte 1 gegeben. Außer der Flüssigkristallzelle 4 sind auf der Leiterplatte 1 ein Lichtkasten 8, eine Lampe 9 und eine integrierte Schaltung 10, welche zur Ansteuerung der Flüssigkristallzelle 4 dient, angeordnet. Dabei sind die Anschlüsse der integrierten Schaltung 10 und der Lampe 9 bzw. deren Fassung, in gewohnter Weise in die Leiterplatte 1 gesteckt und an der Unterseite mit den Leiterbahnen verlötet. Der Lichtkasten 8, welcher keine elektrischen Anschlüsse benötigt, kann ebenfalls durch die Lötung gehalten werden, wenn die Nocken 11 des Lichtkastens 8, welche in entsprechenden Bohrungen der Leiterplatte eingesteckt sind, mit einer lötfähigen Schicht versehen sind.

In Fig. 2 ist noch einmal die Leiterplatte 1 und der Randbereich 3 der Flüssigkristallzelle 4 stark vereinfacht dargestellt. Bei dem Ausführungsbeispiel nach den Figuren 1 und 2 ist der zu dem Schlitz 2 passende Randbereich 3 der Flüssigkristallzelle 4 etwas schmäler gehalten als die Flüssigkristallzelle 4 selbst. Dadurch liegen die Seiten der Flüssigkristallzelle 4 und der Leiterplatte 1 in einer Ebene. Außerdem können die somit gebildeten Absätze zum zusätzlichen Abstützen der Flüssigkristallzelle auf der Leiterplatte dienen, was an sich durch den Rand 11 der zweiten Platte 12 der Flüssigkristallzelle 4 erfolgt.

Bei der in Fig. 3 gezeigten Leiterplatte 13 ist der Schlitz 14 zum Rand hin offen. Lediglich die hakenförmigen Teile 15 und 16 sowie das Lot halten die Flüssigkristallzelle 4 an der Leiterplatte 13. Je nach konstruktiven Erfordernissen können sich hierdurch Vorteile ergeben. Auch eine Verbindung zwischen der Flüssigkristallzelle und der Leiterplatte, bei welcher kein Schlitz vorgesehen ist, sondern lediglich ein Randbereich der Leiterplatte zur Verbindung dient, kann im Einzelfall vorteilhaft sein.

Bei dem in Fig. 4 dargestellten Ausführungsbeispiel ist eine Leiterplatte 18 mit mehreren in einer Reihe liegenden Schlitzen 19, 20, 21 versehen. Die Flüssigkristallzelle 22 hat zu den Stegen zwischen den Schlitzen 19, 20, 21 passende Aussparungen 23, 24. Gegenüber der Anordnung nach Fig. 2 steht bei der Anordnung nach Fig. 3 zwar weniger Länge der Flüssigkristallzelle für die Kontaktierung zur Verfügung, durch die zwischen den Schlitzen 19, 20, 21 liegenden Stege wird jedoch eine größere mechanische Stabilität erreicht. Die in die Schlitze 19 und 21 passenden Ansätze können auch nur zur Justage oder weiteren Befestigung dienen, wenn die Kontakte auf dem mittleren Ansatz untergebracht werden können. Ein Einlöten der Ansätze in die entsprechend metallisierten Schlitze 19 und 21 könnte die Kontaktierung mechanisch entlasten, was insbesondere bei großen Flüssigkristallzellen vorteilhaft ist. Auch mit Vergußmassen können größere Flüssigkristallzellen gehalten werden.

Bei der Anordnung nach Fig. 5 wurden zwei gegenüberliegende Randbereiche 26, 27 einer Flüssigkristallzelle 28 in entsprechende Schlitze zweier Leiterplatten 29, 30 eingefügt und mit den Leiterbahnen durch Löten verbunden. Ebenso erfolgte die Verbindung eines Lichtkastens 31 mit beiden Leiterplatten 29, 30. Es ergibt sich somit eine sehr kompakte und stabile Baugruppe.

Fig. 6 zeigt in vergrößerter Darstellung die Lötverbindung zwischen einer Leiterbahn 6 einer Flüssigkristallzelle 4 und einer Leiterbahn 5 einer Leiterplatte 1 dar. Dabei ist die Leiterbahn 6 der Flüssigkristallzelle 4 an ihrem Endbereich mit einer lötbaren Schicht 33 versehen und das Lot 7 füllt den Winkel zwischen den Leiterbahnen 5 und 6 in an sich bekannter Weise aus. Die Aufbringung einer lötbaren Schicht auf Indium-Zinnoxyd ist an sich bekannt und braucht im Zusammenhang mit der vorliegenden Erfindung nicht näher beschrieben zu werden. Außer Kupfer eignen sich dafür auch andere Metalle.

Die Erfindung ist nicht auf die Ausführungsbeispiele beschränkt, sondern kann in vielfältiger Weise ausgeführt sein. So ist es beispielsweise möglich, die Flüssigkristallzelle 4 in einem von 90° abweichenden Winkel zur Leiterplatte anzuordnen, sofern dieses vorteilhaft sein sollte. Dieses könnte der Fall sein beim Einbau der Flüssigkristallzelle 4 und der Leiterplatte 1 in ein abgeschrägtes Gehäuse oder in ein Armaturenbrett eines Kraftfahrzeugs.

**Ansprüche**

1. Vorrichtung zur elektrisch leitenden Verbindung einer Flüssigkristallzelle (4) mit einer Leiterplatte (1), dadurch gekennzeichnet, daß die Flüssigkristallzelle (4) und die Leiterplatte (1) im wesentlichen aufeinander senkrecht stehen und zueinander passende Leiterbahnen (5, 6) aufweisen, welche innerhalb eines von ihnen gebildeten Winkels durch Lot (7) miteinander verbunden sind.

2. Vorrichtung nach Anspruch 1, dadurch gekennzeichnet, daß in der Leiterplatte (1) in einem Randbereich ein Schlitz (2) zur Aufnahme eines Randbereichs (3) der Flüssigkristallzelle (4) angeordnet ist.

3. Vorrichtung nach Anspruch 2, dadurch gekennzeichnet, daß mehrere Schlitze (19, 20, 21) in einer Reihe angeordnet sind und daß die Flüssigkristallzelle (4) in ihrem Randbereich (3) den zwischen den Schlitzen gebildeten Stegen entsprechende Aussparun gen (23, 24) aufweist.

4. Vorrichtung nach Anspruch 2, dadurch gekennzeichnet, daß der Schlitz (14) zum Rand der Leiterplatte hin teilweise offen ist.

5. Vorrichtung nach Anspruch 1, dadurch gekennzeichnet, daß aus nicht lötbarem Material bestehende Leiterbahnen (6) im Randbereich (3) der Flüssigkristallzelle (4) mit einer lötbaren Schicht versehen sind.

6. Vorrichtung nach Anspruch 5, dadurch gekennzeichnet, daß die Leiterbahnen (6) der Flüssigkristallzelle (4) aus Indium-Zinnoxyd und die lötbare Schicht (33) aus Kupfer besteht.

7. Vorrichtung nach einem der vorhergehenden Ansprüche, dadurch gekennzeichnet, daß elektronische Bauelemente (10), insbesondere eine Ansteuerschaltung für die Flüssigkristallzelle (4), auf der Leiterplatte (1) angeordnet sind.

8. Vorrichtung nach einem der vorhergehenden Ansprüche, dadurch gekennzeichnet, daß eine oder mehrere Lampen (9) auf der Leiterplatte (1) angeordnet sind, deren Anschlüsse mit den Leiterbahnen (5) der Leiterplatte (1) verlötet sind.

9. Vorrichtung nach einem der vorhergehenden Ansprüche, dadurch gekennzeichnet, daß ein Lichtkasten (8) mit der Leiterplatte (1) verbunden ist.

10. Vorrichtung nach einem der vorhergehenden Ansprüche, dadurch gekennzeichnet, daß die Leiterplatte (1) von einer biegsamen Folie gebildet ist.

11. Vorrichtung nach einem der vorhergehenden Ansprüche, dadurch gekennzeichnet, daß zwei gegenüberliegende Randbereiche (26, 27) der Flüssigkristallzelle (28) mit je einer Leiterplatte (29, 30) verbunden sind.

12. Vorrichtung nach einem der vorhergehenden Ansprüche, dadurch gekennzeichnet, daß die Flüssigkristallzelle (4, 28) und die Leiterplatte (1, 29, 30) zusätzlich zur Kontaktierung mit Vergußmasse und/oder Lötung miteinander verbunden sind.

FIG.1

FIG. 2

FIG.3

FIG.4

FIG. 5

FIG.6